# EUROPEAN PATENT SPECIFICATION

(11) **EP 4 492 468 B1**
(45) Date of publication and mention of the grant of the patent: **03.09.2025**
(21) Application number: 23306169.6
(22) Date of filing: 10.07.2023
(51) Int. Cl.: H10F 39/00

(54) **PIXEL**
PIXEL
PIXEL

(43) Date of publication of application: 15.01.2025
(73) Proprietor: STMicroelectronics International N.V., 1228 Plan-les-Ouates, Geneva (CH)
(72) Inventor: FORCOLIN, Giulio, EDINBURGH, EH3 6NG (GB); BIANCHI, Raul Andres, 73800 MYANS (FR); NICHOLSON, Isobel, EDINBURGH, EH11 1EQ (GB)
(74) Representative: Cabinet Beaumont

(56) References cited:
- US-A1- 2020 066 730
- US-A1- 2020 135 956

## Description

### Technical field

The present disclosure relates generally to electronic circuits, for example integrated electronic circuits. The present disclosure is more particularly related to a pixel, for example a pixel implemented in a matrix of identical pixels in a light sensor, for example a time of flight sensor.

### Background art

In order to increase the light path in the silicon of a photodetector of a pixel, for example of the SPAD type ("Single Photon Avalanche Diode"), it is known to add structuration on a face of the pixel which is intended to receive light. The document US2020/135956A is a relevant prior art.

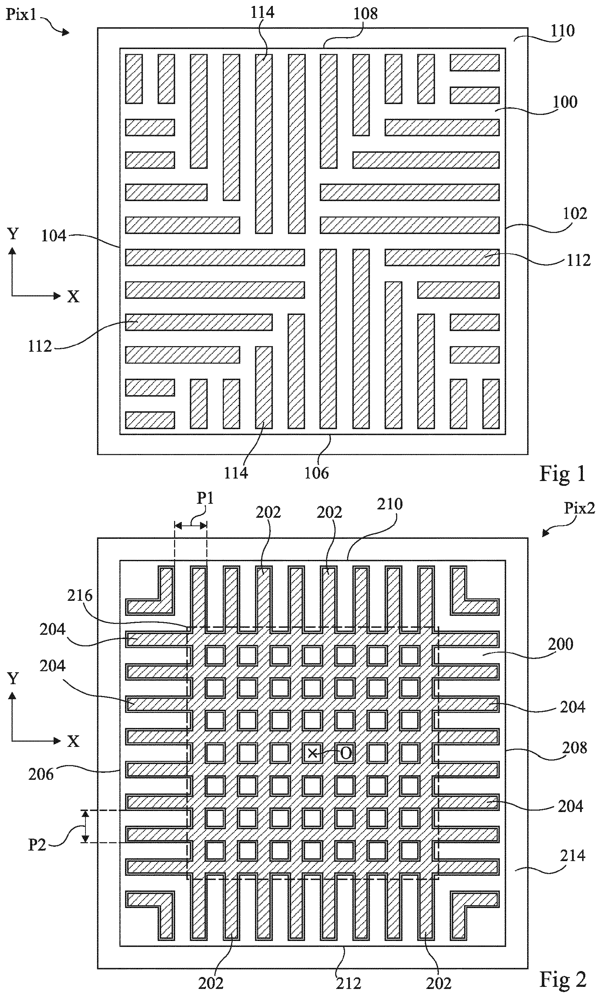

Figure 1 shows an example of a face 100 of a silicon photodetector of a pixel Pix1, the face 100 being intended to receive light and being provided with such structurations. More particularly, Figure 1 is a top view of this structured face 100. The Figure 1 is a simplified reproduction of Figure 2 of the French patent 3 114 190 B1 and the US patent application 2022085084 A1.

The face 100 has two opposite sides 102 and 104 parallel to each other and to a direction Y, and two opposite sides 106 and 108 parallel to each other and to a direction X. The direction X is perpendicular to the direction Y. The face 100 has a square shape in a top view of the pixel Pix1.

The face 100 is one face of a silicon portion forming a photodetector of the pixel Pix1. The photodetector of pixel Pix1 is, for example, laterally delimited by insulation structure 110. The structure 110 are, for example, capacitive deep trench insulation (CDTI).

The pixel Pix1 comprises a plurality of trenches 112 extending in length in the direction X, and a plurality of trenches 114 extending in length in the direction Y. In Figure 1, only few of the trenches 112 and 114 are referenced to not overload the Figure. In Figure 1, the trenches 112 and 114 are hatched.

A first part of trenches 112 extends from the side 102 toward the side 104, and a second part of trenches 112 extends from the side 104 toward the side 102. Similarly, a first part of trenches 114 extends from the side 106 toward the side 108, and a second part of trenches 114 extends from the side 108 toward the side 106. The trenches 112 of the first part of trenches 112 do not join the trenches 112 of the second part of trenches 112. Similarly, the trenches 114 of the first part of trenches 114 do not join the trenches 114 of the second part of trenches 114. Further, the trenches 112 do not cross the trenches 114.

The above-mentioned French patent and US patent application disclose other examples of a face of a silicon photodetector of a pixel provided with first and second trenches, where the first trenches are perpendicular to the second trenches and the first trenches do not cross the second trenches.

These first and second trenches allow to increase the light path in the silicon of the photodetector, thus increasing the quantum efficiency of the pixel. For example, increasing the light path is particularly important when the light received and sensed by the pixel is infra-red light having wavelengths, for example, comprised between 750 nm and 1400 nm, for example a wavelength equal to approximately 950 nm, preferably equal to 950 nm.

Other examples of pixel having a photodetector in silicon where a face of the silicon portion corresponding to the photodetector is provided with first trenches and second trenches perpendicular to the first trenches are known.

### Summary of Invention

There is a need to increase the light path in the silicon of a photodetector of pixel with respect to the known pixels provided with first and second trenches has described above.

One embodiment addresses all or some of the drawbacks of known pixels provided with first and second trenches has described above.

One embodiment provides a pixel comprising:
a silicon portion having a first face configured to received light, for example infra-red light;
first trenches parallel to a first direction and regularly spaced in a second direction perpendicular to the first direction, the first trenches penetrating into the silicon portion from the first face; and
second trenches parallel to the second direction and regularly spaced in the first direction, the second trenches penetrating into the silicon portion from the first face,
wherein:
   in a central region of the first face, the first trenches comprise first notches each penetrating into the silicon from the first face, extending from a first trench comprising said notch toward a neighboring first trench without reaching said neighboring first trench, and being aligned with a corresponding second trench, and/or
   in the central region, the second trenches comprise second notches each penetrating into the silicon form the first face, extending from a second trench comprising said notch toward a neighboring second trench without reaching said neighboring second trench, and being aligned with a corresponding first trench.

According to one embodiment, the first face has two first sides parallel to the first direction and two second sides parallel to the second direction.

According to one embodiment, the first face comprises:
a first region extending from a first one of the first sides toward the central region, the first region comprising only second trenches;
a second region extending from a second one of the first sides toward the central region, the second region comprising only second trenches;
a third region extending from a first one of the second sides toward the central region, the third region comprising only first trenches;
a fourth region extending from a second one of the second sides toward the central region, the fourth region comprising only first trenches.

According to one embodiment, the first and second trenches are devoid of notch outside the central region.

According to one embodiment, at least one V-shaped pattern made of one first trench and one second trench is arranged in each corner of the first face, outside the central region.

According to one embodiment, in each corner of the first face, said at least one V-shaped pattern arranged in said corner is symmetrical with respect to a diagonal of the first face extending from said corner, and has its apex turned toward the center of the first face.

According to one embodiment, for each corner of the first face:
the pixel comprises a plurality a V-shaped patterns each having one first trench and one second trench,
the V-shaped patterns are successively and regularly arranged from said corner toward the center of the first face,
each of said V-shaped patterns has its apex turned toward the center of the first face,
each of said V-shaped patterns is symmetrical with respect to a diagonal extending from said corner, and
the first trenches of these V-shaped patterns comprise first notches in the central region and/or the second trenches of these V-shaped patterns comprise second notches in the central region.

According to one embodiment, in the central region, the first trenches are aligned on first lines of a grid pattern and the second trenches are aligned on second lines of a grid pattern, the first notches being aligned on the second lines of the grid pattern and the second notches being aligned with the first lines.

According to one embodiment, in the first direction, the central region has a length comprised between 50 and 70% of the length of each first side, and, in the second direction, the central region has a length comprised between 50 and 70% of the length of each first side.

According to one embodiment, in the central region, the first and second trenches together with the first and second notches form a pattern similar to a grid pattern.

According to one embodiment, the first and second trenches together with the first and second notches form a pattern having a 90° rotational symmetry with respect to the center of the first face.

According to one embodiment, the first trenches are disposed with a first pitch in the second direction and the second trenches are disposed with a second pitch in the first direction, the first and second pitches being equal to each other and, for example, comprised between 300 and 600 nm, preferably equal to approximately 450 nm.

According to one embodiment, the length of the first notches in the second direction and the length of the second notches in the first direction are comprised between 40 and 60% of the first and second pitches.

According to one embodiment, a width of the first trenches is equal to a width of the second trenches, the width of the first and second trenches being comprised between 150 and 250 nm, for example equal to approximatively 200 nm.

One embodiment provides a method of fabricating the pixel described above, the method comprising :
forming a hard mask on the first face of the pixel;
forming a photoresist mask on the hard mask;
patterning the photoresist mask in order to form therein a first opening exposing the hard mask at each location of a first trench, each location of a second trench, each location of a first notch and each location of a second notch;
etching, through said first openings, second openings in the hard mask; and
etching, through said second openings, the first and second trenches and the first and second notches in the silicon portion.

### Brief description of drawings

The foregoing features and advantages, as well as others, will be described in detail in the following description of specific embodiments given by way of illustration and not limitation with reference to the accompanying drawings, in which:
Figure 1, previously described, is a schematic top view of a face of a silicon photodetector of a pixel;
Figure 2 is a schematic top view of an ideal embodiment of a face of a silicon photodetector of a pixel;
Figure 3 is a schematic top view of an embodiment of a face of a silicon photodetector of a pixel;
Figure 4 is a schematic top view of another embodiment of a face of a silicon photodetector of a pixel;
Figure 5 is a schematic top view of yet another embodiment of a face of a silicon photodetector of a pixel; and
Figure 6 is a schematic top view of yet another embodiment of a face of a silicon photodetector of a pixel.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, the implementation of the described pixels in a light sensor, for example a time of flight sensor, comprising at least one of the described pixels, for example a matrix of pixels identical to one of the described pixels, has not been described, the implementation of such a sensor being in the abilities of those skilled in the art.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10%, and preferably within 5%.

In the following disclosure, a pixel configured to operate with one or several wavelengths in the near infrared, that is to say in the range from 750 nm to 1400 nm, for example a pixel configured to operate with a wavelength equal to substantially 940 nm, is considered as an example. The photodiode of the pixel is further considered to be made of silicon, which has a poor light absorption for these wavelengths. It is further considered, as an example, that the pixel is configured so that its photodiode operates in a single photon avalanche mode, or, say in other words, that the pixel comprises a single photon avalanche diode or SPAD.

The inventors here propose to increase the quantum efficiency of a photodiode of a pixel by providing a structure for dispersing, out of the normal incident angle, the light which reaches the photodiode. As a result, the light pathlength in the photodiode is increased, which lead to an increase of the quantum efficiency.

Figure 2 is a schematic top view of an ideal embodiment of a face 200 of a silicon photodetector of a pixel Pix2.

The face 200 is intended to receive light and is provided with structurations made by trenches 202 and trenches 204.

The face 200 has two opposite sides 206 and 208 parallel to each other and to a direction Y, and two opposite sides 210 and 212 parallel to each other and to a direction X. The direction X is perpendicular to the direction Y. The face 200 has, preferably, a square shape.

The face 200 is one face of a silicon portion forming a photodetector of the pixel Pix2. The photodetector of pixel Pix2 is, for example, laterally delimited by insulation structure 214. The structure 214 are, for example, capacitive deep trench insulation (CDTI). In an alternative example, the structure 214 are deep trench insulation (DTI).

The trenches 202 extend in length in the direction Y, and the trenches 204 extend in length in the direction X. In Figure 2, only few of the trenches 202 and 204 are referenced to not overload the Figure. In Figure 2, the trenches 202 and 204 are hatched.

The trenches 202 are regularly spaced in the X direction. Said otherwise, the trenches 202 are arranged with a pitch P1. Similarly, the trenches 204 are regularly spaced in the Y direction. Said otherwise, the trenches 204 are arranged with a pitch P2. The pitch P1 is equal to the pitch P2.

For example, for a received light in the infra-red, the pitches P1 and P2 are comprised between 300 and 600 nm, for example equal to approximately 450 nm, preferably equal to 450 nm.

For example, the width of the trenches 202 (measured in the direction X) is equal to the width of the trenches 204 (measured in the direction Y). For example, for a received light in the infra-red, the width of the trenches 202 and 204 is comprised between 150 and 250 nm, for example equal to approximately to 200 nm.

Although this is not visible in the view of the Figure 2, the trenches 202 and 204 penetrate into the silicon of the photodetector from the face 200. For example, for a received light in the infra-red, the trenches 202 and 204 penetrate into the silicon on a depth comprised between 200 and 300 nm, for example a depth equal to approximatively 250 nm.

The face 200 comprises a central region 216, delimited in dotted lines in Figure 2. The region 216 for example has a length, measured in the direction X, which is comprised between 50 and 70% of the length of the sides 206 and 208, a length, measured in the direction Y, which is comprised between 50 and 70% of the length of the sides 210 and 212. Preferably, the central region 216 are a square shape.

In the ideal embodiment of Figure 2, the trenches 202 cross the trenches 204 in the central region 216, in order to form a grid pattern in the whole central region 216. Said otherwise, in the central region 216, the trenches 202 are aligned on first lines of a grid pattern and the trenches 204 are aligned on second lines of a grid pattern, the first lines being orthogonal to the second lines and being parallel to the direction Y.

In the ideal embodiment of Figure 2, the pixel Pix2 comprises a region which extends from the side 206 toward, preferably until, the central region 216 and which comprises only trenches 204, or said otherwise, which is devoid of trenches 202. The pixel Pix2 further comprises a region which extends from the side 208 toward, preferably until, the central region 216 and which comprises only trenches 204, or said otherwise, which is devoid of trenches 202. The pixel Pix2 comprises a region which extends from the side 210 toward, preferably until, the central region 216 and which comprises only trenches 202, or said otherwise, which is devoid of trenches 204. The pixel Pix2 further comprises a region which extends from the side 212 toward, preferably until, the central region 216 and which comprises only trenches 202, or said otherwise, which is devoid of trenches 204.

In the ideal embodiment of Figure 2, the pixel Pix2 comprises, in each corner of the face 200, a V-shaped pattern made of one trench 202 and one trench 204. In each corner, this V-shaped pattern has its apex turned toward the center O of the face 200. Preferably, in each corner of the face 200, the V-shaped pattern arranged in this corner is symmetrical with respect to a diagonal of the face 200 which extends from this corner.

It has been found by simulation that the pixel Pix2 of Figure 2 has an optimized pattern made of trenches 202 and 204 for improving the light absorption in the photodetector of the Pix2 with respect to a pixel having a similar photodetector but with trenches 112 and 114 of the type described in relation with Figure 1.

However, in view of the dimension of the trenches 202 and 204 and of their pitch P1 and P2, the pixel Pix2 may be not manufacturable with the usual microelectronic fabrication processes. For example, when using a mask made of a photoresist patterned with openings at the location of the trenches 202 and 204, the portions of the photoresist left in place between these opening may not adhere sufficiently and be stripped out, which lead to defect in the pattern of the trenches 202 and 204 compared to the one described in relation with Figure 2. This is, for example, more particularly the case when the dimensions of the trenches 202 and 204 and their pitches P1 and P2 are chosen, or optimized, for a received light in the infra-red.

Thus, rather than providing trenches 202 and 204 which form a grid pattern in the central region 216 of the pixel Pix2, it is here proposed a pixel Pix3 similar to pixel Pix2 but in which the trenches 202 and 204 are replaced by similar trenches respectively 302 and 304 which comprise, in a central region 316 of the pixel Pix3, notches 320 and 322.

More particularly, the trenches 302 are parallel to the direction Y and the trenches 304 are parallel to the direction 306. Further, the trenches 302 comprise, in the central region 316, notches 320 which each extends in the direction X from a corresponding trench 302 toward a neighboring trench 302 but without reaching this neighboring trench 302, the notch 320 being aligned with a trench 304. Similarly, the trenches 304 comprise, in the central region 316, notches 322 which each extends in the direction Y from a corresponding trench 304 toward a neighboring trench 304 but without reaching this neighboring trench 304, the notch 322 being aligned with a trench 302.

Thus, in the central region 316, the pattern formed by the trenches 302 and 304 and the notches 320 and 322 is similar to a grid pattern but is not identical to a grid pattern. This allows to improve the absorption in the photodetector of the pixel Pix3 in a manner similar to the grid pattern of the pixel Pix2, and, in the same time, this allows for the pixel Pix3 to be manufactured using usual steps of the microelectronic fabrication processes.

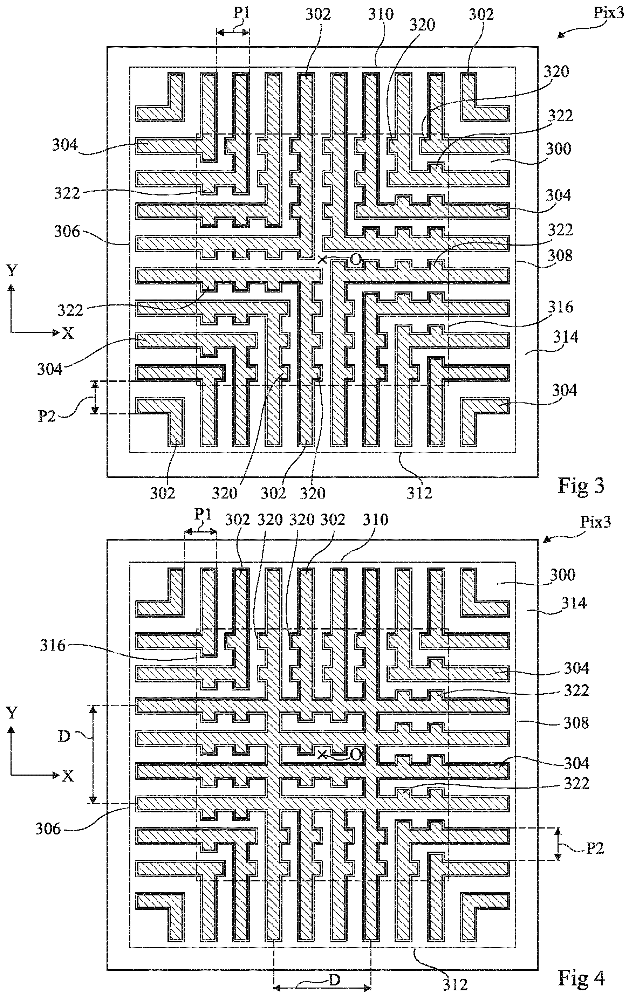

Figure 3 illustrate an embodiment of the pixel Pix3. More particularly, the Figure 3 is a schematic top view of an embodiment of a face 300 of a silicon photodetector of the pixel Pix3.

The face 300 is intended to receive light and is provided with structurations made by trenches 302 and trenches 304.

The face 300 has two opposite sides 306 and 308 parallel to each other and to a direction Y, and two opposite sides 310 and 312 parallel to each other and to a direction X. The direction X is perpendicular to the direction Y. The face 300 has, preferably, a square shape.

The face 300 is one face of a silicon portion forming a photodetector of the pixel Pix3. The photodetector of pixel Pix3 is, for example, laterally delimited by insulation structure 314. The structure 314 are, for example, capacitive deep trench insulation (CDTI). In an alternative example, the structure 314 are deep trench insulation (DTI).

The trenches 302 extend in length in the direction Y, and the trenches 304 extend in length in the direction X. In Figure 3, only few of the trenches 302 and 304 are referenced to not overload the Figure. In Figure 3, the trenches 302 and 304 are hatched.

The trenches 302, respectively 304, are similar to the trenches 202, respectively 204, previously described, at the difference that the trenches 302 and 304 do not form a complete grid pattern in the central region 316 of the pixel Pix3. Thus, unless specified otherwise, all that have been indicated for the trenches 202 and 204 applies to the trenches respectively 302 and 304. Furthermore, in the pixel Pix3, the central region 316 of the face 300 (delimited by dotted lines in Figure 3) is similar to the central region 216 of the face 200 of the pixel Pix2. Thus, unless indicated otherwise, all that have been described for the region 216 applies to the central region 316. In particular, the dimensions of the region 316 with respect to the sides 306, 308, 310 and 312 are identical to the dimensions of the region 216 with respect to the sides 206, 208, 210 and 212 respectively.

As indicated before and shown on Figure 3, in the central region 316, the trenches 302 comprise notches 320 and the trenches 304 comprise notches 322. Only few of the notches 320 and 322 are referenced in Figure 3 in order to not overload the Figure. Thus, in the central region, the trenches 302 and the notches 322 are aligned on first lines of a grid pattern, the trenches 304 and the notches 324 are aligned on second lines of the grid pattern, the first lines being parallel to the direction Y and the second lines being aligned with the direction X. Preferably, there is no notch 322 which is not aligned with a corresponding trench 302, and there is no notch 324 which is not aligned with a corresponding trench 304.

The notches 320 and 322 penetrate into the silicon of the pixel Pix3 from the face 300. Preferably, the notches 320 and 322 penetrate the silicon of the photodetector of the pixel Pix3 on the same depth as the trenches 302 and 304.

Preferably, the width of the notches 322 (measured in the direction X) is equal to the width of the trenches 302, and the width of the notches 324 (measured in the direction Y) is equal to the width of the trenches 304.

Preferably, the length of the notches 322 (measured in the direction Y) and the length of the notches 324 (measured in the direction X) are comprised between 40 and 60% of respectively the pitch P2 of the trenches 304 and the pitch P1 of the trenches 302, the pitches P1 and P2 being preferably equal to each other.

Preferably, the pixel Pix3 comprises, similarly to pixel Pix2:
a first region which extends from the side 306 toward, preferably until, the central region 316 and which comprises only trenches 304, or said otherwise, which is devoid of trenches 302;
a second region which extends from the side 308 toward, preferably until, the central region 316 and which comprises only trenches 304, or said otherwise, which is devoid of trenches 302;
a third region which extends from the side 310 toward, preferably until, the central region 316 and which comprises only trenches 302, or said otherwise, which is devoid of trenches 304; and
a fourth region which extends from the side 312 toward, preferably until, the central region 316 and which comprises only trenches 302, or said otherwise, which is devoid of trenches 304.

Preferably, as in the pixel Pix2 the grid pattern is located only on the central region 216 of the face 200, and as the notches 320 and 322 help to mimic the pattern shown on Figure 2, the trenches 302 and 304 are devoid of notches 320 and 322 in the first, second, third and fourth regions defined above.

As for the pixel Pix2, preferably, the pixel Pix3 comprises, in each corner of the face 300, one or a plurality of V-shaped patterns each made of one trench 302 and one trench 304. In each corner, each V-shaped pattern arranged in the corner has its apex turned toward the center O of the face 300. Preferably, in each corner of the face 300, each V-shaped pattern arranged in this corner is symmetrical with respect to a diagonal of the face 300 which extends from this corner.

In the example of Figure 3, the pixel Pix3 comprises only one V-shaped pattern in each corner.

Preferably, as in the pixel Pix2 the grid pattern is located only on the central region 216 of the face 200, and as the notches 320 and 322 help to mimic the pattern shown on Figure 2, the trenches 302 and 304 of the V-shaped pattern disposed in the corners of the face 300 which are outside of the central region, and are devoid of notches 322 and 324.

Preferably, the trenches 302 comprise notches 320 only in the central region 316 and the trenches 304 comprise notches 322 only in the central region 316.

Preferably, as it is the case in the embodiment of Figure 3, for each corner of the face 300:
the pixel Pix3 comprises a plurality of V-shaped patterns each made of one trench 302 and one trench 304;
the V-shaped patterns are successively and regularly arranged from this corner toward the center O of the face 300,
each of the V-shaped patterns has its apex turned toward the center O of the pixel, and
each of the V-shaped patterns is symmetrical with respect to a diagonal extending from this corner.

Preferably, as it is the case in the embodiment of Figure 3, independently from the fact that the trenches 302 and 304 are arranged in V-shaped patterns, in the central region 316, for each trench 302, the notches 320 are arranged along the trench 302 with the pitch P2 of the trenches 304, and, for each trench 304, the notches 322 are arranged along the trench 304 with the pitch P1 of the trenches 302.

Preferably, as it is the case in the embodiment of Figure 3, independently from the fact that the notches 320 are arranged with the pitch P2 and the notches 322 are arranged with the pitch P1, and independently from the fact that the trenches 302 and 304 are arranged in V-shaped patterns, for each trench 302, the notches 320 of this trench 302 are all disposed on a same side of the trench 302, and, for each trench 304, the notches 322 of this trench 304 are all disposed on the same side of the trench 304.

In the embodiment of Figure 3, preferably, each trench 302 and each trench 322 belong to one corresponding V-shaped pattern. Said in other words, there is no trench 302 or 304 which does not belong to a V-shaped pattern. In particular there is no pair of a trench 302 and a trench 304 in which the trenches 302 and 304 cross each other and form a X-shaped pattern.

Preferably, as it is the case in the embodiment of Figure 3, independently from the fact that the trenches 302 and 304 are arranged in V-shaped patterns and of the pitches of the notches 320 and 322, the pattern made by the trenches 302 and 304 has a rotational symmetry by a rotation of 90° with respect to the center O of the face 300. Thank to this rotational symmetry, the pixel Pix3 is insensitive to the polarization of this incident light.

According to an embodiment, the process of fabricating the pixel Pix3 comprises the following successive steps:
forming a hard mask on the face 300;
forming a photoresist mask on the hard mask;
patterning the photoresist mask in order to form therein a first openings exposing the hard mask at each location of a trench 302, each location of a trench 304, each location of a notch 320 and each location of a notch 322;
etching the hard mask through the first openings to form therein second openings; and
etching the silicon of the photodetector of the pixel Pix3 through the second openings, to form therein the trenches 302 and 304 and the notches 320 and 322.

With the above process, it may be impossible to fabricate the pixel Pix2 of Figure 2 as most of the portion of the photoresist mask left in place between the first openings between etching the hard mask have small dimensions in the directions X and Y and each form a small square. On the contrary, the above process may be used for fabricating the pixel Pix3 because, the portion of the photoresist mask left in place before the etching of the hard mask have bigger dimensions in the directions X and Y, and, for example, each forms a strip. Thus, this portion of the photoresist mask adhere better to the hard mask.

Figure 4 is a schematic top view of another embodiment of the face 300 of the silicon photodetector of the pixel Pix3.

Pixels Pix3 of Figures 3 and 4 have a lot of element in common, and only the differences between these two pixels will be detailed. In particular, unless indicated otherwise, all that have been indicated for the pixel Pix3 of Figure 3 applies to the pixel Pix3 of Figure 4.

In particular, compared to the pixel Pix3 of Figure 3, in the pixel Pix3 of Figure 4, the trenches 302 and 304 are not only arranged in V-shaped patterns, but also in at least one square-shaped pattern, the at least one square-shaped pattern being preferably arranged in the central region 316.

For example, as shown in the example of Figure 4, a first trench 302 and a second trench 302 spaced from each other by a distance D taken in the X direction each crosses a first trench 304 and a second trench 304 spaced from each other by the same distance D. Preferably, the distance D is at least twice the pitches P1 and P2.

Preferably, the square-shaped pattern formed by the crossing of these four trenches 302 and 304 is centered on the center O of the face 300.

Although, in the example of Figure 4, there is only one square-shaped pattern formed by two trenches 302 and two trenches 304, in other examples where the pixel Pix3 comprises more than one squared pattern, preferably the side of each square-shaped pattern is longer than the pitches P1 and P2 and/or each of the square-shaped pattern is centered on the center O of the face 300.

Compared with the pixel Pix3 of Figure 3, the pixel Pix3 does not have any rotational symmetry with respect to the center O of the pixel Pix3.

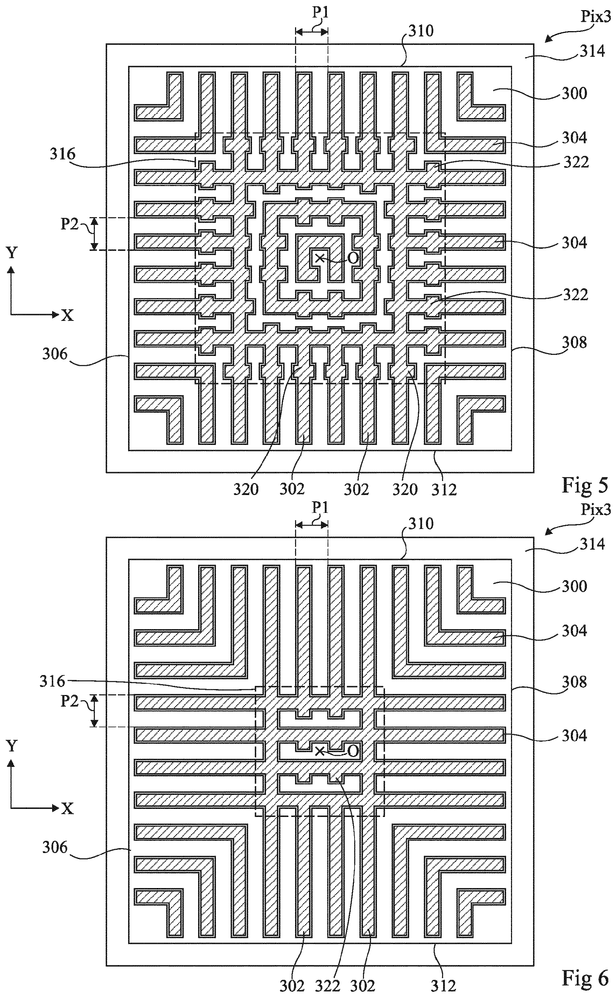

Figure 5 is a schematic top view of another embodiment of the face 300 of the silicon photodetector of the pixel Pix3.

Pixels Pix3 of Figures 5 and 4 have a lot of element in common, and only the differences between these two pixels will be detailed. In particular, unless indicated otherwise, all that have been indicated for the pixel Pix3 of Figure 4 applies to the pixel Pix3 of Figure 5.

In particular, compared to the pixel Pix3 of Figure 4, in the pixel Pix3 of Figure 5, there is more than one square-shaped pattern formed by two trenches 302 and two trenches 304. For example, in the Figure 5, there are two square-shaped patterns, each of which being formed by two trenches 302 and two trenches 304.

For example, as it is the case in the example of Figure 5, the pixel Pix3 does not comprise, in the central region 316, any V-shaped pattern made of one trench 302 and one trench 304. Said in other words, the pixel Pix3 does not comprise, in the example of Figure 5, any V-shaped pattern formed by one trench 302 and on trench 304 in which the trench 302 comprises notches 320 and the trench 304 comprises notches 322.

For example, as it is the case in the example of Figure 5, the Pix3 comprises, in each corner, outside of the central region 316, more than one V-shaped pattern formed by one trench 302 and one trench 304, these patterns being devoid of notches 320 and 322 as there are arranged outside of the central region. Further, each of these V-shaped patterns has its apex turned toward the center O of the face 300. Further, in each corner of the face 300, the V-shaped patterns arranged in the corner are successively and regularly arranged from this corner toward the center O of the face 300. Further, in each corner of the face 300, each of the V-shaped patterns arranged in the corner is symmetrical with respect to the diagonal of the face 300 which extends from this corner.

In the example of the Figure 5, in each corner of the face 300, the pixel Pix3 comprises two successive V-shaped patterns devoid of notches 320 and 322.

Further, as it is the case in the example of Figure 5, in the central region 316, at least some of trenches 302, preferably all the trenches 302, each comprises notches 320 on both sides (taken along the length of the trench 302) of the trench 302, and, similarly, at least some of trenches 304, preferably all the trenches 304, each comprises notches 322 on both sides (taken along the length of the trench 304) of the trench 304. Although not illustrated, in other example, each trench 302 comprises, in the central region 316, notches 320 on only one side of the trench 302, and/or each trench 304 comprises, in the central region 316, notches 322 on only one side of the trench 304.

Figure 6 is a schematic top view of another embodiment of the face 300 of the silicon photodetector of the pixel Pix3.

Pixels Pix3 of Figures 4 and 6 have a lot of element in common, and only the differences between these two pixels will be detailed. In particular, unless indicated otherwise, all that have been indicated for the pixel Pix3 of Figure 4 applies to the pixel Pix3 of Figure 6.

In particular, compared to the pixel Pix3 of Figure 4, in the pixel Pix3 of Figure 5, the central region 316 of the pixel Pix3 is smaller.

Further, and independently from the fact the region 316 is smaller, there is no V-shaped pattern whose trenches 302 and 304 comprise notches 320 and 322 respectively.

Further, and independently from the fact the region 316 is smaller and from the fact that there is no no V-shaped pattern whose trenches 302 and 304 comprise notches 320 and 322 respectively, in the pixel Pix3 of Figure 6, in the central region 316, the trenches 304 comprise notches 322 but the trenches 302 are devoid of notch 320 in the central region. Although not illustrated, the contrary is also possible, meaning that in other examples, in the central region 316, the trenches 302 comprise notches 320 but the trenches 304 are devoid of notch 322.

Simulations have shown that, for a received light in the infra-red and for a photodetector having a portion of epitaxial silicon with a thickness of 10 µm, the pixel Pix3 of Figure 3 exhibit an improvement of 3.4% of the absorption with respect to a similar pixel Pix1, the pixel Pix3 of Figure 4 exhibit an improvement of 3.8% of the absorption with respect to a similar pixel Pix1, the pixel Pix3 of Figure 5 exhibit an improvement of 3.0% of the absorption with respect to a similar pixel Pix1, and the pixel Pix3 of Figure 6 exhibit an improvement of 3.4% of the absorption with respect to a similar pixel Pix1.

Preferably, in the pixel Pix3, as illustrated in all the embodiments previously described in relation with Figure 3, 4, 5 and 6, there is no square-shaped pattern formed by the intersection of two tranches 302 with two corresponding trenches 304 whose sides length is equal to the pitches P1 and P2. Said in other words, there is no square-shaped pattern formed by the intersection of two successive (or neighboring) trenches 302 with two successive (or neighboring) trenches 304.

Preferably, in the pixel Pix3, as illustrated in all the embodiments previously described in relation with Figure 3, 4, 5 and 6, outside of the central region 316, the trenches 302 and 304 do not comprise any notch respectively 320 and 322.

Although it has not been explicitly indicated previously, in the pixel Pix3 each trench 302 which comprises a portion outside the region 316 and a portion inside the region 316 is devoid of notch 320 on its portion outside the region 316 and may comprises notches 322 on its portion inside the region 316. Similarly, in the pixel Pix3 each trench 304 which comprises a portion outside the region 316 and a portion inside the region 316 is devoid of notch 322 on its portion outside the region 316 and may comprises notches 322 on its portion inside the region 316.

Finally, the practical implementation of the embodiments and variants described herein is within the capabilities of those skilled in the art based on the functional description provided hereinabove.

## Claims

1. A pixel (Pix3) comprising:
a silicon portion having a first face (300) configured to received light, for example infra-red light;
first trenches (302) parallel to a first direction (Y) and regularly spaced in a second direction (X) perpendicular to the first direction (Y), the first trenches (302) penetrating into the silicon portion from the first face (300); and
second trenches (304) parallel to the second direction (X) and regularly spaced in the first direction (Y), the second trenches (304) penetrating into the silicon portion from the first face (300),
wherein:
in a central region (316) of the first face (300), the first trenches (302) comprise first notches (320) each penetrating into the silicon from the first face, extending from a first trench (320) comprising said notch (320) toward a neighboring first trench (302) without reaching said neighboring first trench (302), and being aligned with a corresponding second trench (304), and/or
in the central region (316), the second trenches (304) comprise second notches (322) each penetrating into the silicon form the first face (300), extending from a second trench (304) comprising said notch (322) toward a neighboring second trench (304) without reaching said neighboring second trench (304), and being aligned with a corresponding first trench (302).

2. The pixel according to claim 1, wherein the first face (300) has two first sides (306, 308) parallel to the first direction (Y) and two second sides (310, 312) parallel to the second direction (X).

3. The pixel according to claim 2, wherein the first face (300) comprises:
a first region extending from a first one of the first sides (306, 308) toward the central region (316), the first region comprising only second trenches (304);
a second region extending from a second one of the first sides (306, 308) toward the central region (316), the second region comprising only second trenches (304);
a third region extending from a first one of the second sides (310, 312) toward the central region (316), the third region comprising only first trenches (302);
a fourth region extending from a second one of the second sides (310, 312) toward the central region (316), the fourth region comprising only first trenches (302).

4. The pixel according to claim 3, wherein the first and second trenches (302, 304) are devoid of notch (320, 322) outside the central region (316).

5. The pixel according to any of claims 2 to 4, wherein at least one V-shaped pattern made of one first trench (302) and one second trench (304) is arranged in each corner of the first face (300), outside the central region (316).

6. The pixel according to claim 5, wherein, in each corner of the first face (300), said at least one V-shaped pattern arranged in said corner is symmetrical with respect to a diagonal of the first face (300) extending from said corner, and has its apex turned toward the center (O) of the first face (300).

7. The pixel according to any of claims 2 to 6, wherein, for each corner of the first face (300):
the pixel (Pix3) comprises a plurality a V-shaped patterns each having one first trench (302) and one second trench (304),
the V-shaped patterns are successively and regularly arranged from said corner toward the center (O) of the first face (300),
each of said V-shaped patterns has its apex turned toward the center (O) of the first face (300),
each of said V-shaped patterns is symmetrical with respect to a diagonal extending from said corner, and
the first trenches (302) of these V-shaped patterns comprise first notches (320) in the central region (316) and/or the second trenches (304) of these V-shaped patterns comprise second notches (322) in the central region (316).

8. The pixel according to any of claims 1 to 7, wherein, in the central region (316), the first trenches (302) are aligned on first lines of a grid pattern and the second trenches (304) are aligned on second lines of a grid pattern, the first notches (320) being aligned on the second lines of the grid pattern and the second notches (322) being aligned with the first lines.

9. The pixel according to any of claims 2 to 8, wherein, in the first direction (Y), the central region (316) has a length comprised between 50 and 70% of the length of each first side (306, 308), and, in the second direction (X), the central region (316) has a length comprised between 50 and 70% of the length of each first side (308, 310).

10. The pixel according to any of claims 1 to 9, wherein, in the central region (316), the first and second trenches (302, 304) together with the first and second notches (320, 322) form a pattern similar to a grid pattern.

11. The pixel according to any of claims 1 to 10, wherein the first and second trenches (302, 304) together with the first and second notches (320, 322) form a pattern having a 90° rotational symmetry with respect to the center (O) of the first face (300).

12. The pixel according to any of claims 1 to 11, wherein the first trenches (302) are disposed with a first pitch (P1) in the second direction (X) and the second trenches (304) are disposed with a second pitch (P2) in the first direction (X), the first and second pitches (P1, P2) being equal to each other and, for example, comprised between 300 and 600 nm, preferably equal to approximately 450 nm.

13. The pixel according to claim 12, wherein the length of the first notches (320) in the second direction (X) and the length of the second notches (322) in the first direction (Y) are comprised between 40 and 60% of the first and second pitches (P1, P2).

14. The pixel according to any of claims 1 to 13, wherein a width of the first trenches is equal to a width of the second trenches, the width of the first and second trenches being comprised between 150 and 250 nm, for example equal to approximatively 200 nm.

15. A method of fabricating the pixel (Pix3) according to any of claims 1 to 14, comprising:
forming a hard mask on the first face (300) of the pixel; forming a photoresist mask on the hard mask;
patterning the photoresist mask in order to form therein a first opening exposing the hard mask at each location of a first trench (302), each location of a second trench (304), each location of a first notch (320) and each location of a second notch (322);
etching, through said first openings, second openings in the hard mask; and
etching, through said second openings, the first and second trenches (302, 304) and the first and second notches (320, 322) in the silicon portion.

## Patentansprüche

1. Pixel (Pix3), aufweisend:
einen Siliziumabschnitt mit einer ersten Fläche (300), die konfiguriert ist zum empfangen von Licht, beispielsweise Infrarotlicht;
erste Gräben (302), die parallel zu einer ersten Richtung (Y) verlaufen und in einer zweiten Richtung (X) senkrecht zur ersten Richtung (Y) in regelmäßigen Abständen angeordnet sind, wobei die ersten Gräben (302) von der ersten Fläche (300) aus in den Siliziumabschnitt eindringen; und
zweite Gräben (304), die parallel zur zweiten Richtung (X) verlaufen und in der ersten Richtung (Y) in regelmäßigen Abständen angeordnet sind, wobei die zweiten Gräben (304) von der ersten Fläche (300) aus in den Siliziumabschnitt eindringen,
wobei:
in einem Mittelbereich (316) der ersten Fläche (300) die ersten Gräben (302) erste Kerben (320) aufweisen, die jeweils von der ersten Fläche in das Silizium eindringen, sich von einem ersten Graben (320), der die Kerbe (320) aufweist, zu einem benachbarten ersten Graben (302) erstrecken, ohne den benachbarten ersten Graben (302) zu erreichen, und mit einem entsprechenden zweiten Graben (304) ausgerichtet sind, und/oder
im Mittelbereich (316) die zweiten Gräben (304) zweite Kerben (322) aufweisen, die jeweils von der ersten Fläche (300) in das Silizium eindringen, sich von einem zweiten Graben (304), der die Kerbe (322) aufweist, zu einem benachbarten zweiten Graben (304) erstrecken, ohne den benachbarten zweiten Graben (304) zu erreichen, und mit einem entsprechenden ersten Graben (302) ausgerichtet sind.

2. Pixel gemäß Anspruch 1, wobei die erste Fläche (300) zwei erste Seiten (306, 308) parallel zur ersten Richtung (Y) und zwei zweite Seiten (310, 312) parallel zur zweiten Richtung (X) aufweist.

3. Pixel gemäß Anspruch 2, wobei die erste Fläche (300) Folgendes aufweist:
einen ersten Bereich, der sich von einer ersten der ersten Seiten (306, 308) in Richtung des Mittelbereichs (316) erstreckt, wobei der erste Bereich nur zweite Gräben (304) aufweist;
einen zweiten Bereich, der sich von einer zweiten der ersten Seiten (306, 308) in Richtung des Mittelbereichs (316) erstreckt, wobei der zweite Bereich nur zweite Gräben (304) aufweist;
einen dritten Bereich, der sich von einer ersten der zweiten Seiten (310, 312) in Richtung des Mittelbereichs (316) erstreckt, wobei der dritte Bereich nur erste Gräben (302) aufweist;
einen vierten Bereich, der sich von einer zweiten der zweiten Seiten (310, 312) in Richtung des Mittelbereichs (316) erstreckt, wobei der vierte Bereich nur erste Gräben (302) aufweist.

4. Pixel gemäß Anspruch 3, wobei die ersten und zweiten Gräben (302, 304) außerhalb des Mittelbereichs (316) keine Kerben (320, 322) aufweisen.

5. Pixel gemäß einem der Ansprüche 2 bis 4, wobei mindestens ein V-förmiges Muster aus einem ersten Graben (302) und einem zweiten Graben (304) in jeder Ecke der ersten Fläche (300) außerhalb des mittleren Bereichs (316) angeordnet ist.

6. Pixel gemäß Anspruch 5, wobei in jeder Ecke der ersten Fläche (300) dass mindestens eine in dieser Ecke angeordnete V-förmige Muster symmetrisch zu einer Diagonalen der ersten Fläche (300) ist, die sich von dieser Ecke aus erstreckt, und seine Spitze zum Mittelpunkt (O) der ersten Fläche (300) hin ausgerichtet ist.

7. Pixel gemäß einem der Ansprüche 2 bis 6, wobei für jede Ecke der ersten Fläche (300):
das Pixel (Pix3) mehrere V-förmige Muster aufweist, die jeweils einen ersten Graben (302) und einen zweiten Graben (304) aufweisen,
die V-förmigen Muster nacheinander und regelmäßig von der Ecke zur Mitte (O) der ersten Fläche (300) angeordnet sind,
jedes der V-förmigen Muster mit seiner Spitze zur Mitte (O) der ersten Fläche (300) hin ausgerichtet ist,
jedes der V-förmigen Muster symmetrisch zu einer von der Ecke ausgehenden Diagonalen ist, und
die ersten Gräben (302) dieser V-förmigen Muster erste Kerben (320) im mittleren Bereich (316) und/oder die zweiten Gräben (304) dieser V-förmigen Muster zweite Kerben (322) im Mittelbereich (316) aufweisen.

8. Pixel gemäß einem der Ansprüche 1 bis 7, wobei im Mittelbereich (316) die ersten Gräben (302) auf ersten Linien eines Gittermusters ausgerichtet sind und die zweiten Gräben (304) auf zweiten Linien eines Gittermusters ausgerichtet sind, wobei die ersten Kerben (320) auf den zweiten Linien des Gittermusters ausgerichtet sind und die zweiten Kerben (322) mit den ersten Linien ausgerichtet sind.

9. Pixel gemäß einem der Ansprüche 2 bis 8, wobei in der ersten Richtung (Y) der Mittelbereich (316) eine Länge zwischen 50 und 70 % der Länge jeder ersten Seite (306, 308) aufweist und in der zweiten Richtung (X) der Mittelbereich (316) eine Länge zwischen 50 und 70 % der Länge jeder ersten Seite (308, 310) aufweist.

10. Pixel gemäß einem der Ansprüche 1 bis 9, wobei in dem Mittelbereich (316) die ersten und zweiten Gräben (302, 304) zusammen mit den ersten und zweiten Kerben (320, 322) ein Muster bilden, das einem Gittermuster ähnelt.

11. Pixel gemäß einem der Ansprüche 1 bis 10, wobei die ersten und zweiten Gräben (302, 304) zusammen mit den ersten und zweiten Kerben (320, 322) ein Muster bilden, das eine 90°-Rotationssymmetrie in Bezug auf den Mittelpunkt (O) der ersten Fläche (300) aufweist.

12. Pixel gemäß einem der Ansprüche 1 bis 11, wobei die ersten Gräben (302) mit einem ersten Abstand (P1) in der zweiten Richtung (X) angeordnet sind und die zweiten Gräben (304) mit einem zweiten Abstand (P2) in der ersten Richtung (X) angeordnet sind, wobei der erste und der zweite Abstand (P1, P2) gleich sind und beispielsweise zwischen 300 und 600 nm, vorzugsweise bei etwa 450 nm liegt.

13. Pixel gemäß Anspruch 12, wobei die Länge der ersten Kerben (320) in der zweiten Richtung (X) und die Länge der zweiten Kerben (322) in der ersten Richtung (Y) zwischen 40 und 60 % des ersten und zweiten Abstands (P1, P2) liegt.

14. Pixel gemäß einem der Ansprüche 1 bis 13, wobei eine Breite der ersten Gräben gleich einer Breite der zweiten Gräben ist, wobei die Breite der ersten und zweiten Gräben zwischen 150 und 250 nm liegt, beispielsweise etwa 200 nm beträgt.

15. Verfahren zur Herstellung des Pixels (Pix3) gemäß einem der Ansprüche 1 bis 14, aufweisend:
Ausbilden einer Hartmaske auf der ersten Fläche (300) des Pixels;
Ausbilden einer Fotolackmaske auf der Hartmaske;
Strukturieren der Fotolackmaske, um darin eine erste Öffnung zu bilden, die die Hartmaske an jeder Stelle eines ersten Grabens (302), jeder Stelle eines zweiten Grabens (304), jeder Stelle einer ersten Kerbe (320) und jeder Stelle einer zweiten Kerbe (322) freilegt;
Ätzen von zweiten Öffnungen in der Hartmaske durch die ersten Öffnungen hindurch; und
Ätzen der ersten und zweiten Gräben (302, 304) und der ersten und zweiten Kerben (320,322) in dem Siliziumabschnitt durch die zweiten Öffnungen hindurch.

## Revendications

1. Pixel (Pix3) comprenant :
une partie en silicium ayant une première face (300) configurée pour recevoir de la lumière, par exemple de la lumière infrarouge ;
des premières tranchées (302) parallèles à une première direction (Y) et régulièrement espacées dans une deuxième direction (X) perpendiculaire à la première direction (Y), les premières tranchées (302) pénétrant à l'intérieur de la partie en silicium à partir de la première face (300) ; et
des deuxièmes tranchées (304) parallèles à la deuxième direction (X) et régulièrement espacées dans la première direction (Y), les deuxièmes tranchées (304) pénétrant à l'intérieur de la partie en silicium à partir de la première face (300),
dans lequel :
dans une région centrale (316) de la première face (300), les premières tranchées (302) comprennent des premières encoches (320) qui pénètrent chacune à l'intérieur du silicium depuis la première face, qui s'étendent depuis une première tranchée (320) comprenant ladite encoche (320) vers une première tranchée voisine (302) sans atteindre ladite première tranchée voisine (302), et qui sont alignées avec une deuxième tranchée correspondante (304), et/ou
dans la région centrale (316), les deuxièmes tranchées (304) comprennent des deuxièmes encoches (322) qui pénètrent chacune à l'intérieur du silicium depuis la première face (300), qui s'étendent depuis une deuxième tranchée (304) comprenant ladite encoche (322) vers une deuxième tranchée voisine (304) sans atteindre ladite deuxième tranchée voisine (304), et qui sont alignées avec une première tranchée correspondante (302).

2. Pixel selon la revendication 1, dans lequel la première face (300) a deux premiers côtés (306, 308) parallèles à la première direction (Y) et deux deuxièmes côtés (310, 312) parallèles à la deuxième direction (X).

3. Pixel selon la revendication 2, dans lequel la première face (300) comprend :
une première région qui s'étend depuis un premier des premiers côtés (306, 308) vers la région centrale (316), la première région comprenant uniquement des deuxièmes tranchées (304) ;
une deuxième région qui s'étend depuis un deuxième des premiers côtés (306, 308) vers la région centrale (316), la deuxième région comprenant uniquement des deuxièmes tranchées (304) ;
une troisième région qui s'étend depuis un premier des deuxièmes côtés (310, 312) vers la région centrale (316), la troisième région comprenant uniquement des premières tranchées (302) ;
une quatrième région qui s'étend depuis un deuxième des deuxièmes côtés (310, 312) vers la région centrale (316), la quatrième région comprenant uniquement des premières tranchées (302).

4. Pixel selon la revendication 3, dans lequel les première et deuxième tranchées (302, 304) sont dépourvues d'encoche (320, 322) en-dehors de la région centrale (316).

5. Pixel selon l'une quelconque des revendications 2 à 4, dans lequel au moins un motif en forme de V constitué d'une première tranchée (302) et d'une deuxième tranchée (304) est disposé dans chaque coin de la première face (300), à l'extérieur de la région centrale (316).

6. Pixel selon la revendication 5, dans lequel, dans chaque coin de la première face (300), ledit au moins un motif en V disposé dans ledit coin est symétrique par rapport à une diagonale de la première face (300) s'étendant depuis ledit coin, et a son sommet tourné vers le centre (O) de la première face (300).

7. Pixel selon l'une quelconque des revendications 2 à 6, dans lequel, pour chaque coin de la première face (300) :
le pixel (Pix3) comprend une pluralité de motifs en forme de V qui ont chacun une première tranchée (302) et une deuxième tranchée (304),
les motifs en V sont disposés successivement et régulièrement depuis ledit coin vers le centre (O) de la première face (300),
chacun desdits motifs en V a son sommet tourné vers le centre (O) de la première face (300),
chacun desdits motifs en forme de V est symétrique par rapport à une diagonale s'étendant depuis ledit coin, et
les premières tranchées (302) de ces motifs en V comprennent des premières encoches (320) dans la région centrale (316) et/ou les deuxièmes tranchées (304) de ces motifs en V comprennent des deuxièmes encoches (322) dans la région centrale (316).

8. Pixel selon l'une quelconque des revendications 1 à 7, dans lequel, dans la région centrale (316), les premières tranchées (302) sont alignées sur des premières lignes d'un motif de grille et les deuxièmes tranchées (304) sont alignées sur des deuxièmes lignes d'un motif de grille, les premières encoches (320) étant alignées sur les deuxièmes lignes du motif de grille et les deuxièmes encoches (322) étant alignées avec les premières lignes.

9. Pixel selon l'une quelconque des revendications 2 à 8, dans lequel, dans la première direction (Y), la région centrale (316) a une longueur comprise entre 50 et 70 % de la longueur de chaque premier côté (306, 308), et, dans la deuxième direction (X), la région centrale (316) a une longueur comprise entre 50 et 70 % de la longueur de chaque premier côté (308, 310).

10. Pixel selon l'une quelconque des revendications 1 à 9, dans lequel, dans la région centrale (316), les première et deuxième tranchées (302, 304) ainsi que les première et deuxième encoches (320, 322) forment un motif similaire à un motif de grille.

11. Pixel selon l'une quelconque des revendications 1 à 10, dans lequel les première et deuxième tranchées (302, 304) ainsi que les première et deuxième encoches (320, 322) forment un motif ayant une symétrie de rotation de 90° par rapport au centre (O) de la première face (300).

12. Pixel selon l'une quelconque des revendications 1 à 11, dans lequel les premières tranchées (302) sont disposées avec un premier pas (P1) dans la deuxième direction (X) et les deuxièmes tranchées (304) sont disposées avec un deuxième pas (P2) dans la première direction (X), les premier et deuxième pas (P1, P2) étant égaux entre eux et, par exemple, compris entre 300 et 600 nm, de préférence égaux à environ 450 nm.

13. Pixel selon la revendication 12, dans lequel la longueur des premières encoches (320) dans la deuxième direction (X) et la longueur des deuxièmes encoches (322) dans la première direction (Y) sont comprises entre 40 et 60 % des premier et deuxième pas (P1, P2).

14. Pixel selon l'une quelconque des revendications 1 à 13, dans lequel une largeur des premières tranchées est égale à une largeur des deuxièmes tranchées, la largeur des première et deuxième tranchées étant comprise entre 150 et 250 nm, par exemple égale à environ 200 nm.

15. Procédé de fabrication du pixel (Pix3) selon l'une quelconque des revendications 1 à 14, comprenant :
la formation d'un masque dur sur la première face (300) du pixel ;
la formation d'un masque photorésistant sur le masque dur ;
la mise en forme du masque de résine photosensible afin d'y former une première ouverture exposant le masque dur à chaque emplacement d'une première tranchée (302), à chaque emplacement d'une deuxième tranchée (304), à chaque emplacement d'une première encoche (320) et à chaque emplacement d'une deuxième encoche (322) ;
la gravure, à travers lesdites premières ouvertures, de deuxièmes ouvertures dans le masque dur ; et
la gravure, à travers lesdites deuxièmes ouvertures, les première et deuxième tranchées (302, 304) et les première et deuxième encoches (320, 322) dans la partie en silicium.
